(19) Europäisches Patentamt
European Patent Office
Office européen des brevets

(11) **EP 3 034 183 B1**

(12) **FASCICULE DE BREVET EUROPEEN**

(45) Date de publication et mention de la délivrance du brevet:
**06.02.2019 Bulletin 2019/06**

(51) Int Cl.:
***B06B 1/02*** *(2006.01)*      ***H03H 9/02*** *(2006.01)*

(21) Numéro de dépôt: **15200208.5**

(22) Date de dépôt: **15.12.2015**

(54) **DISPOSITIF ACOUSTIQUE D'ISOLATION GALVANIQUE**

AKUSTISCHE VORRICHTUNG ZUR GALVANISCHEN ISOLIERUNG

ACOUSTIC DEVICE FOR GALVANIC ISOLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2014 FR 1462598**

(43) Date de publication de la demande:
**22.06.2016 Bulletin 2016/25**

(73) Titulaires:
• **STMicroelectronics (Tours) SAS**
  **37100 Tours (FR)**
• **Université François-Rabelais**
  **37020 Tours (FR)**

(72) Inventeurs:
• **NGO, Sophie**
  **37000 TOURS (FR)**
• **CERTON, Dominique**
  **37550 SAINT AVERTIN (FR)**
• **ALQUIER, Daniel**
  **37000 TOURS (FR)**

(74) Mandataire: **Cabinet Beaumont**
  **4, Place Robert Schuman**
  **B.P. 1529**
  **38025 Grenoble Cedex 1 (FR)**

(56) Documents cités:
**EP-A1- 1 779 784      FR-A1- 2 954 014**
**US-A- 5 870 351      US-A1- 2007 215 964**

• VANAGAS G ET AL: "Investigation of dynamic parameters of multilayered microelectromechanical membranes with finite element modeling", MATERIALS SCIENCE EDITORIAL BOARD OF JOURNAL MATERIALS SCIENCE LITHUANIA, vol. 14, no. 2, 2008, pages 175-178, XP002750543, ISSN: 1392-1320
• CHING-HSIANG CHENG ET AL: "A flexible capacitive micromachined ultrasonic transducer (CMUT) array with increased effective capacitance from concave bottom electrodes for ultrasonic imaging applications", ULTRASONICS SYMPOSIUM (IUS), 2009 IEEE INTERNATIONAL, IEEE, PISCATAWAY, NJ, USA, 20 September 2009 (2009-09-20), pages 996-999, XP031654630, ISBN: 978-1-4244-4389-5

**EP 3 034 183 B1**

## Description

Domaine

La présente demande concerne un dispositif acoustique d'isolation galvanique.

Exposé de l'art antérieur

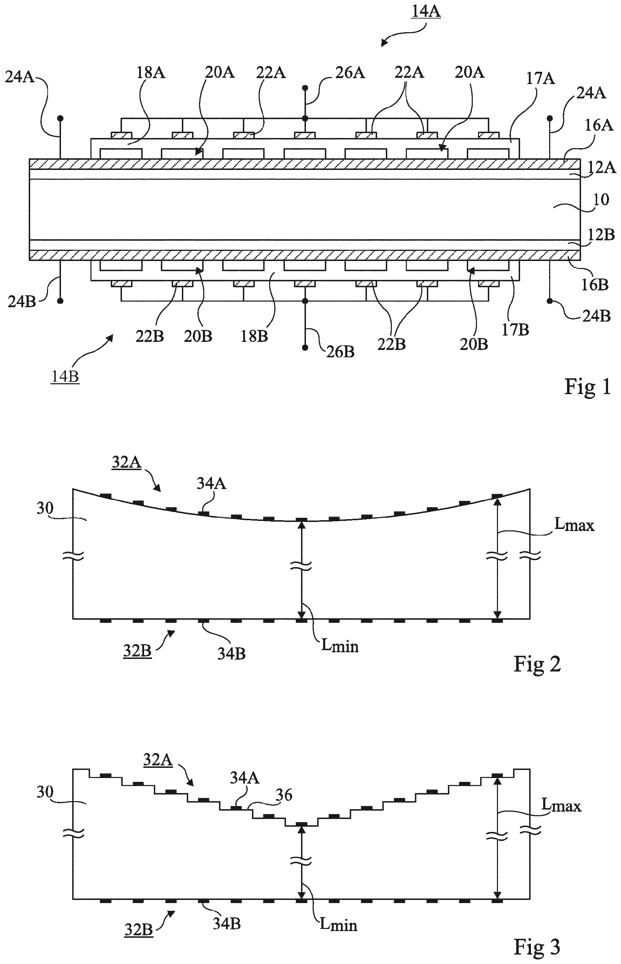

La figure 1 est une vue en coupe représentant schématiquement un exemple de dispositif acoustique d'isolation galvanique décrit dans le brevet français N° 2954014 (B9908) de la demanderesse.

Ce dispositif comprend un substrat 10 en silicium revêtu sur sa face supérieure d'une couche 12A de matériau isolant. Sur la couche 12A est formé un réseau 14A de transducteurs électro-acoustiques à membrane vibrante. Ces transducteurs sont souvent désignés dans la technique par l'acronyme CMUT de l'anglais "Capacitive Micromachined Ultrasonic Transducer". Ces transducteurs comprennent une couche conductrice 16A formée sur la couche isolante 12A et formant une première électrode commune à tous les transducteurs. Au-dessus de la couche conductrice 16A est formée une couche 17A en un matériau diélectrique. Des membranes 18A sont définies dans la couche 17A au-dessus de cavités 20A. Sur les membranes 18A et en regard des cavités 20A, sont formées des secondes électrodes 22A. Un ou plusieurs contacts 24A sont formés sur la première électrode 16A. Les électrodes 22A sont connectées à un noeud 26A.

Symétriquement, la face inférieure du substrat 10 comprend des éléments 12B, 14B, 16B, 17B, 18B, 20B, 22B, 24B et 26B homologues des éléments 12A, 14A, 16A, 17A, 18A, 20A, 22A, 24A et 26A.

En fonctionnement, une tension de polarisation continue est appliquée entre les contacts 24A et 26A du premier réseau 14A de transducteurs et entre les contacts 24B et 26B du deuxième réseau 14B de transducteurs. Une tension alternative de fréquence $f_0$ (signal d'entrée) est appliquée au premier réseau 14A de transducteurs, entre les contacts 24A et 26A. Cette tension alternative provoque la mise en oscillation à la fréquence $f_0$ des membranes 18A des transducteurs du réseau 14A. Les ondes acoustiques ultrasonores produites se propagent dans le substrat 10 en direction du réseau 14B de transducteurs. L'épaisseur du substrat est choisie pour favoriser la propagation des ondes acoustiques de fréquence $f_0$. Les ondes acoustiques transmises par le substrat 10 atteignent les transducteurs du deuxième réseau 14B, ce qui provoque la vibration de leur membrane 18B. Il en résulte l'apparition d'une tension alternative de fréquence $f_0$ (signal de sortie) entre les contacts 24B et 26B.

Lorsque la fréquence du signal d'entrée s'écarte de la fréquence $f_0$ pour laquelle l'épaisseur du substrat 10 a été choisie, on observe une forte atténuation de l'amplitude du signal de sortie. Ainsi, un tel dispositif acoustique d'isolation galvanique ne fonctionne bien que si la fréquence du signal d'entrée reste proche d'une fréquence déterminée $f_0$. Ceci implique qu'il faut associer au dispositif acoustique d'isolation galvanique un générateur de signal d'entrée alternatif fournissant une fréquence qui reste proche de la fréquence $f_0$ de fonctionnement optimal du dispositif. La prévision d'un tel générateur fournissant, sans dérive, une fréquence précise entraîne que ce générateur doit être relativement sophistiqué et que son coût est élevé.

Il existe donc un besoin d'un dispositif acoustique d'isolation galvanique qui puisse accepter un signal d'entrée alternatif dont la fréquence est comprise dans une plage relativement large. Le document "A flexible capacitive micromachined ultrasonic transducer (CMUT) array with increased effective capacitance from concave bottom electrodes for ultrasonic imaging applications",Ultrasonics Symposium (IUS), 2009 IEEE; Ching-Hsiang Cheng; Chen Chao; Xiaomei Shi; Wallace Leung; ISBN 978-1-4244-4389-5 divulgue un example de dispositif de réseau de transducteurs ultrasoniques micro-usinés capacitifs flexibles (CMUT).

Résumé

Ainsi, un mode de réalisation prévoit un dispositif acoustique d'isolation galvanique selon la revendication 1, ledit dispositif comprenant un substrat apte à transmettre une onde acoustique, un premier réseau de transducteurs électro-acoustiques à membrane vibrante disposés sur une première face du substrat, et un deuxième réseau de transducteurs électro-acoustiques à membrane vibrante disposés sur une deuxième face opposée du substrat, dans lequel le substrat présente un gradient d'épaisseur effective entre les première et deuxième faces.

Selon un mode de réalisation, le substrat est constitué de silicium non poreux et de silicium poreux, et les première et deuxième faces sont planes et parallèles entre elles, l'interface entre le silicium non poreux et le silicium poreux étant non plane.

Selon un mode de réalisation, l'épaisseur du silicium non poreux varie de manière discrète.

Selon un mode de réalisation, la surface du silicium non poreux en contact avec le silicium poreux est concave.

Selon un mode de réalisation, le substrat est constitué d'un seul matériau.

Selon un mode de réalisation, l'épaisseur du matériau varie de manière discrète.

Selon un mode de réalisation, l'une au moins des première et deuxième faces est concave.

Selon un mode de réalisation, le substrat comprend en outre des zones de silicium poreux disposées à la périphérie du substrat et s'étendant de la première à la deuxième face.

D'après l'invention, l'onde acoustique a une fréquence comprise entre une fréquence haute $f_{max}$ et une

fréquence basse $f_{min}$, et le substrat a une épaisseur effective maximale $L_{max}$ et une épaisseur effective minimale $L_{min}$ choisies telles que :

$$L_{max} = n\frac{c}{2f_{min}},$$

et

$$L_{min} = n\frac{c}{2f_{max}},$$

n étant un entier, et c désignant la célérité des ondes acoustiques dans le ou les matériaux du substrat.

Selon un mode de réalisation, le dispositif comprend des moyens aptes à modifier la polarisation des transducteurs de manière à adapter la fréquence de résonance des transducteurs à la fréquence de l'onde acoustique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, représente schématiquement un exemple de dispositif acoustique d'isolation galvanique décrit dans le brevet français N° 2954014 ;
la figure 2 est une vue en coupe représentant schématiquement un dispositif acoustique d'isolation galvanique ;
la figure 3 est une vue en coupe représentant schématiquement un mode de réalisation du dispositif de la figure 2 ;
la figure 4 est une vue en coupe représentant schématiquement une variante de réalisation du dispositif de la figure 2 ;
la figure 5 est une vue en coupe représentant schématiquement un autre mode de réalisation d'un dispositif acoustique d'isolation galvanique ;
la figure 6 est une vue en coupe représentant schématiquement une variante de réalisation du dispositif de la figure 5 ;
la figure 7 est une vue en coupe représentant schématiquement une variante de réalisation du dispositif de la figure 6 ; et
la figure 8 est une vue en coupe représentant schématiquement une autre variante de réalisation du dispositif de la figure 6.

### Description détaillée

Dans les figures 2 à 8, de mêmes éléments ont été désignés par de mêmes références et, de plus ces figures ne sont pas tracées à l'échelle. Par souci de clarté, dans ces figures, les transducteurs de type CMUT sont représentés de façon simplifiée. Par ailleurs, des termes tels que "supérieur", "inférieur", "latéral", etc., s'appliquent à des dispositifs orientés de la façon illustrée dans les figures correspondantes, étant entendu que, dans la pratique, ces dispositifs peuvent être orientés différemment. Dans la suite de la description, sauf indication contraire, le terme "sensiblement" signifie "à 10% près".

La figure 2 est une vue en coupe représentant schématiquement un dispositif acoustique d'isolation galvanique prévu pour transmettre des signaux alternatifs entre des réseaux d'entrée et de sortie de transducteurs électro-acoustiques à membrane vibrante.

Le dispositif comprend un substrat 30 en tout matériau adapté à transmettre des ondes acoustiques ultrasonores. Des premier et deuxième réseaux 32A et 32B de transducteurs électro-acoustiques 34A et 34B de type CMUT sont disposés respectivement sur les faces supérieure et inférieure du substrat 30. Chacun des éléments de ces réseaux est constitué de la façon décrite en relation avec la figure 1. La face inférieure du substrat 30 est plane et la surface supérieure du substrat est concave. Il en résulte que le substrat 30 présente un gradient d'épaisseur entre ses faces supérieure et inférieure. L'épaisseur du substrat 30 varie d'une valeur maximale $L_{max}$ à une valeur minimale $L_{min}$, les épaisseurs $L_{max}$ et $L_{min}$ du substrat favorisant la propagation d'ondes acoustiques de fréquences respectives $f_{min}$ et $f_{max}$.

Ainsi, le dispositif de la figure 2 transmet avec sensiblement la même intensité des signaux d'entrée alternatifs ayant chacun une fréquence différente comprise dans une plage de fréquences relativement large s'étendant d'une fréquence basse $f_{min}$ à une fréquence haute $f_{max}$.

La figure 3 est une vue en coupe représentant schématiquement un mode de réalisation du dispositif de la figure 2. Dans ce mode de réalisation, la face supérieure concave du substrat 30 est structurée en paliers échelonnés 36. Dans la vue en coupe représentée, par souci de simplification, un unique transducteur 34A est disposé sur la largeur de chaque palier 36. Du fait que les paliers ont des surfaces supérieures planes, chaque transducteur 34A s'étend parallèlement aux transducteurs 34B.

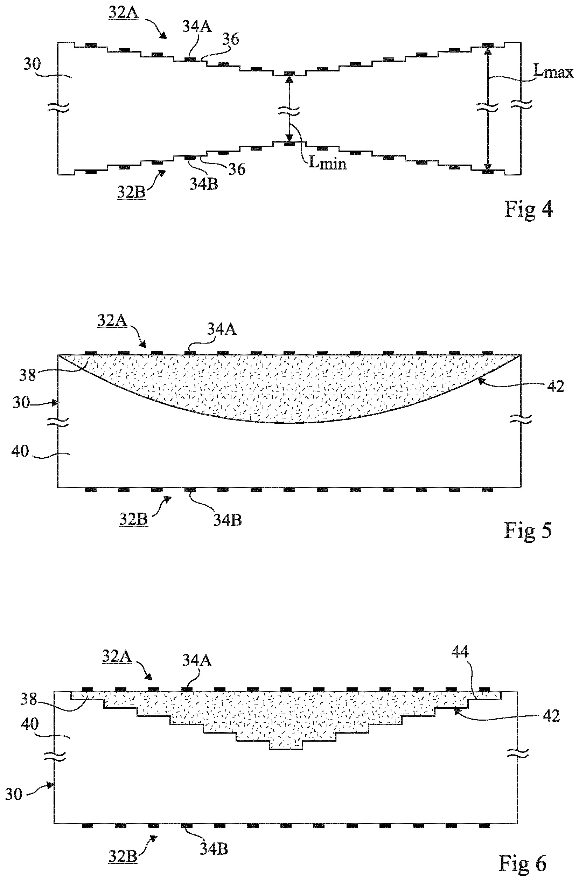

La figure 4 est une vue en coupe représentant schématiquement une variante de réalisation du dispositif de la figure 2. Dans cette variante, les faces supérieure et inférieure du substrat 30 sont toutes deux concaves et structurées en paliers échelonnés 36.

A titre d'exemple, dans les dispositifs des figures 2 à 4, le substrat 30 est en silicium ou en verre. Le profil de la face supérieure, et éventuellement celui de la face inférieure, du substrat peut être obtenu par gravure. Dans le cas où les faces supérieure et inférieure du substrat 30 sont toutes deux concaves, deux portions de substrat peuvent être gravées séparément puis collées l'une à l'autre, par exemple par collage moléculaire.

La figure 5 est une vue en coupe représentant schématiquement un autre mode de réalisation d'un dispositif acoustique d'isolation galvanique prévu pour transmettre des signaux alternatifs entre des réseaux d'entrée et de sortie de transducteurs électro-acoustiques à membrane vibrante.

Le dispositif comprend un substrat 30, et des premier et deuxième réseaux 32A et 32B de transducteurs 34A et 34B de type CMUT. Le substrat 30 comprend une partie supérieure 38 en silicium poreux et une partie inférieure 40 en silicium non poreux, par exemple en silicium monocristallin. Les faces supérieure et inférieure du substrat 30 sont planes et parallèles entre elles. La surface supérieure 42 de la partie 40 en contact avec la partie 38 est concave.

En fonctionnement, quand une onde se propage dans le substrat 30 d'un transducteur 34A à un transducteur 34B en regard, elle traverse du silicium poreux et du silicium non poreux. Pour un substrat ayant une épaisseur donnée de silicium poreux et une épaisseur donnée de silicium non poreux, on appelle épaisseur effective du substrat l'épaisseur qu'aurait un substrat de silicium non poreux traversé en la même durée par une onde acoustique de même fréquence.

Le substrat 30 présente un gradient d'épaisseur effective. Ainsi, comme cela a été exposé en relation avec le dispositif de la figure 2, le dispositif de la figure 5 transmet efficacement des signaux dans une plage de fréquences relativement large. En choisissant les épaisseurs des parties 38 et 40 et le profil de la surface 42 pour que l'épaisseur effective du substrat 30 varie de $L_{min}$ à $L_{max}$, cette plage de fréquences s'étendra de $f_{min}$ à $f_{max}$.

En outre, du fait que les faces supérieure et inférieure du substrat 30 sont planes, les opérations de dépôt et de gravure nécessaires à la réalisation des transducteurs 34A et 34B sont simplifiées par rapport au cas où ces faces sont courbes ou comprennent des portions situées à des hauteurs différentes.

A titre d'exemple, le silicium poreux peut être obtenu en déposant sur la surface supérieure d'un substrat en silicium un masque résistif dont l'épaisseur varie de manière complémentaire à l'épaisseur de silicium poreux que l'on souhaite former, puis en effectuant une étape d'anodisation électrochimique, c'est-à-dire en immergeant le substrat dans un bain électrolytique et en faisant circuler un courant à travers le masque et ce substrat.

La figure 6 est une vue en coupe schématique d'une variante de réalisation du dispositif de la figure 5. Dans cette variante, au lieu d'être régulièrement concave, la surface supérieure 42 de la partie 40 est structurée en paliers échelonnés 44. Ainsi, l'épaisseur de la partie supérieure 38 du substrat varie de façon discrète. Il en résulte que la réalisation du silicium poreux est simplifiée. A titre d'exemple, les diverses épaisseurs de silicium poreux peuvent être obtenues en répétant des étapes de dépôt d'un masque isolant sur des portions de la face supérieure d'un substrat, et d'anodisation électrochimique de ce substrat.

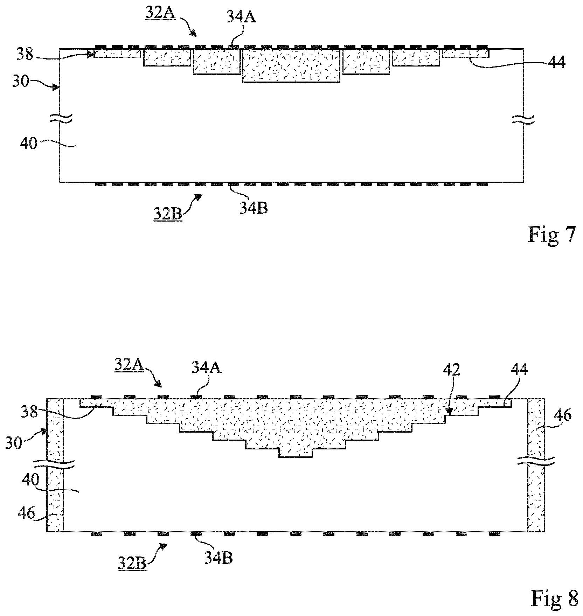

La figure 7 est une vue en coupe représentant schématiquement une variante de réalisation du dispositif de la figure 6. Dans cette variante, les portions de silicium poreux de diverses profondeurs sont disjointes. Plusieurs transducteurs 34A sont disposés sur la largeur de chaque portion de silicium poreux.

On notera que des réalisations échelonnées telles que celles des figures 5 à 7 peuvent comprendre seulement un nombre limité de paliers, par exemple 4 comme cela est représenté en figure 7. Le nombre d'étapes nécessaires à la réalisation d'un tel dispositif est donc limité.

La figure 8 est une vue en coupe représentant schématiquement une autre variante de réalisation du dispositif de la figure 6. Dans cette variante, du silicium poreux 46 s'étend à la périphérie du substrat 30, de la face supérieure à la face inférieure de celui-ci. Ce silicium poreux 46 limite la propagation d'éventuelles ondes acoustiques transverses. Il en résulte une diminution des effets de bord. Cette disposition peut également être prévue dans les dispositifs des figures 2 à 4 dans les cas où le substrat 30 est en silicium, et dans les dispositifs des figures 5 à 7.

Dans les dispositifs des figures 2 à 8, les valeurs $L_{min}$ et $L_{max}$ de l'épaisseur effective du substrat sont choisies en fonction de la fréquence du signal d'entrée alternatif allant d'une fréquence minimale $f_{min}$ à une fréquence maximale $f_{max}$. Cette épaisseur effective correspond à l'épaisseur réelle du substrat dans les dispositifs des figures 2 à 4, et tient compte de la superposition de silicium poreux et de silicium non poreux dans les dispositifs des figures 5 à 8. En particulier, $L_{min}$ et $L_{max}$ sont choisies telles que :

$$L_{max} = n \frac{c}{2 f_{min}},$$

et

$$L_{min} = n \frac{c}{2 f_{max}},$$

n étant un entier et c désignant la célérité du son dans le matériau ou l'ensemble de matériaux du substrat dans une direction allant d'un réseau de transducteurs à un autre. A titre d'exemple, pour $f_{min}$=11 MHz, $f_{max}$=13 MHz, n=2 et un substrat 30 en silicium, c=8433 m.s$^{-1}$, $L_{min}$=648,7 $\mu$m, et $L_{max}$=766,7 $\mu$m.

Des modes de réalisation particuliers ont été décrits. Diverses variantes et modifications apparaîtront à l'homme de l'art. En pratique, les réseaux 32A et 32B comportent un grand nombre de transducteurs 34A et 34B, par exemple plusieurs milliers à plusieurs dizaines de milliers de transducteurs.

Dans les dispositifs des figures 2 à 8, on a décrit des substrats à épaisseur effective variable. Pour réduire encore plus les différences d'intensités entre des signaux transmis à des fréquences différentes, on peut prévoir d'adapter la fréquence de résonance des transducteurs 34A et 34B à la fréquence du signal d'entrée alternatif. Ceci peut se faire, par exemple, comme cela est décrit dans la demande de brevet américaine N° 2013/135970 (B11326) de la demanderesse, sans modifier les caractéristiques structurelles des transducteurs 34A et 34B, mais seulement en modifiant la tension de polarisation de ces transducteurs en fonction de la fréquence du signal alternatif. On pourra prévoir un asservissement entre la fréquence du signal d'entrée et cette tension de polarisation.

Différents types de transducteurs électro-acoustiques à membrane vibrante peuvent être utilisés dans les dispositifs des figures 2 à 8. Par exemple, on peut prévoir d'utiliser des transducteurs de type CMUT tels que ceux décrits dans le brevet américain N° 8791624 (B10453) de la demanderesse pour découpler les tensions alternatives appliquées aux transducteurs 34A et 34B des tensions continues servant à polariser ces transducteurs.

Dans les dispositifs des figures 2 à 8, le substrat 30 est symétrique par rapport à un axe central. Le substrat 30 pourrait toutefois ne pas être symétrique. En outre, la face supérieure et éventuellement la face inférieure du substrat des dispositifs des figures 2 à 4 peuvent avoir des profils autres que concaves. De manière analogue, on peut modifier le profil de l'interface entre le silicium poreux et le silicium non poreux du substrat des dispositifs des figures 5 à 8.

De manière analogue à ce qui a été décrit en relation avec la figure 7, plusieurs transducteurs 34A peuvent être disposés sur la largeur de chaque palier 36 des dispositifs des figures 3 et 4, et plusieurs transducteurs 34A peuvent être disposés sur la face supérieure du substrat en regard d'un même palier 44 des dispositifs des figures 6 et 8.

Dans les dispositifs des figures 5 à 8, pour faire varier l'épaisseur effective du substrat, de façon analogue à ce qui a été décrit en relation avec la figure 4, du silicium poreux peut être formé du côté de la face inférieure et du côté de la face supérieure du substrat.

Divers modes de réalisation avec diverses variantes ont été décrits ci-dessus. L'homme de l'art pourra combiner divers éléments de ces divers modes de réalisation et variantes sans faire preuve d'activité inventive.

## Revendications

1. Dispositif acoustique d'isolation galvanique comprenant un substrat (30) apte à transmettre une onde acoustique, un premier réseau (32A) de transducteurs électro-acoustiques (34A) à membrane vibrante disposés sur une première face du substrat, et un deuxième réseau (32B) de transducteurs électro-acoustiques (34B) à membrane vibrante disposés sur une deuxième face opposée du substrat, dans lequel le substrat présente une variation d'épaisseur effective entre les première et deuxième faces le long de la dimension latérale dudit substrat, et l'onde acoustique a une fréquence comprise entre une fréquence haute $f_{max}$ et une fréquence basse $f_{min}$, et le substrat (30) a une épaisseur effective maximale $L_{max}$ et une épaisseur effective minimale $L_{min}$ choisies telles que :

$$L_{max} = n\frac{c}{2f_{min}},$$

et

$$L_{min} = n\frac{c}{2f_{max}},$$

n étant un entier, et c désignant la célérité des ondes acoustiques dans le ou les matériaux du substrat.

2. Dispositif selon la revendication 1, dans lequel le substrat (30) est constitué de silicium non poreux (40) et de silicium poreux (38), et les première et deuxième faces sont planes et parallèles entre elles, l'interface entre le silicium non poreux et le silicium poreux étant non plane.

3. Dispositif selon la revendication 2, dans lequel l'épaisseur du silicium non poreux varie de manière discrète.

4. Dispositif selon la revendication 2 ou 3, dans lequel la surface (42) du silicium non poreux (40) en contact avec le silicium poreux (38) est concave.

5. Dispositif selon la revendication 1, dans lequel le substrat (30) est constitué d'un seul matériau.

6. Dispositif selon la revendication 5, dans lequel l'épaisseur du matériau varie de manière discrète.

7. Dispositif selon la revendication 5 ou 6, dans lequel l'une au moins des première et deuxième faces est concave.

8. Dispositif selon l'une quelconque des revendications 1 à 7, dans lequel le substrat (30) comprend en outre des zones de silicium poreux (46) disposées à la périphérie du substrat et s'étendant de la première à la deuxième face.

9. Dispositif selon l'une quelconque des revendications 1 à 8, dans lequel le dispositif comprend des moyens aptes à modifier la polarisation des transducteurs (32A, 32B) de manière à adapter la fréquence de résonance des transducteurs (34A, 34B) à la fréquence de l'onde acoustique.

**Patentansprüche**

1. Akustische Vorrichtung zur galvanischen Isolation, die ein Substrat (30) aufweist, welches fähig ist, eine akustische Welle zu übertragen, ein erstes Netzwerk (32A) von elektroakustischen Wandlern (34A) mit vibrierender Membran, die auf einer ersten Oberfläche des Substrates angeordnet sind, und ein zweites Netzwerk (32B) von elektroakustischen Wandlern (34B) mit vibrierender Membran, die auf einer zweiten gegenüberliegenden Oberfläche des Substrates angeordnet sind, wobei das Substrat eine effektive Dickenveränderung zwischen den ersten und zweiten Oberflächen entlang der seitlichen Ausdehnung des Substrates hat, und wobei die akustische Welle eine Frequenz im Bereich einer hohen Frequenz $f_{max}$ zu einer niedrigen $f_{min}$ hat, und wobei das Substrat (30) eine maximale effektive Dicke $L_{max}$ und eine minimale effektive Dicke $L_{min}$ hat, die so ausgewählt sind, dass Folgendes gilt:

$$L_{max} = n\frac{c}{2f_{min}},$$

und

$$L_{min} = n\frac{c}{2f_{max}},$$

wobei n eine ganze Zahl ist, und c die Geschwindigkeit der akustischen Wellen in dem Material bzw. den Materialien des Substrates bezeichnet.

2. Vorrichtung nach Anspruch 1 wobei das Substrat (30) aus nicht porösem Silicium (40) und aus porösem Silicium (38) gemacht ist, und wobei die ersten und zweiten Oberflächen eben und parallel zueinander sind, wobei die Schnittstelle zwischen dem nicht porösen Silicium und dem porösen Silicium nicht eben ist.

3. Vorrichtung nach Anspruch 2, wobei die Dicke des nicht porösen Siliciums in diskreter Weise variiert.

4. Vorrichtung nach Anspruch 2 oder 3, wobei die Oberfläche (42) des nicht porösen Siliciums (40) in Kontakt mit dem porösen Silicium (38) konkav ist.

5. Vorrichtung nach Anspruch 1, wobei das Substrat (30) aus einem einzigen Material gemacht ist.

6. Vorrichtung nach Anspruch 5, wobei die Dicke des Materials in diskreter Weise variiert.

7. Vorrichtung nach Anspruch 5 oder 6, wobei zumindest eine der ersten und zweiten Oberflächen konkav ist.

8. Vorrichtung nach einem der Ansprüche 1 bis 7, wobei das Substrat (30) weiter Bereiche (46) von porösem Silicium aufweist, die am Rand des Substrates angeordnet sind und sich von der ersten zur zweiten Oberfläche erstrecken.

9. Vorrichtung nach einem der Ansprüche 1 bis 8, die weiter Mittel aufweist, die fähig sind, die Polarisation der Wandler (32A, 32B) in einer Weise zu modifizieren, dass die Resonanzfrequenz der Wandler (34A, 34B) an die Frequenz der akustischen Welle angepasst wird.

**Claims**

1. An acoustic galvanic isolation device comprising a substrate (30) capable of transmitting an acoustic wave, a first network (32A) of vibrating membrane electroacoustic transducers (34A) arranged on a first surface of the substrate, and a second network (32B) of vibrating membrane electroacoustic transducers (34B) arranged on a second opposite surface of the substrate, wherein the substrate has an effective thickness variation between the first and second surfaces along the lateral dimension of said substrate, and the acoustic wave has a frequency in the range from a high frequency $f_{max}$ to a low frequency $f_{min}$, and the substrate (30) has a maximum effective thickness $L_{max}$ and a minimum effective thickness $L_{min}$ selected to be such that:

$$L_{max} = n\frac{c}{2f_{min}},$$

and

$$L_{min} = n\frac{c}{2f_{max}},$$

n being an integer, and c designating the velocity of acoustic waves in the material(s) of the substrate.

2. The device of claim 1, wherein the substrate (30) is made of non-porous silicon (40) and of porous silicon (38), and the first and second surfaces are planar and parallel to each other, the interface between the non-porous silicon and the porous silicon being non-planar.

3. The device of claim 2, wherein the thickness of the non-porous silicon varies discretely.

4. The device of claim 2 or 3, wherein the surface (42) of the non-porous silicon (40) in contact with the porous silicon (38) is concave.

5. The device of claim 1, wherein the substrate (30) is made of a single material.

6. The device of claim 5, wherein the thickness of the material varies discretely.

7. The device of claim 5 or 6, wherein at least one of the first and second surfaces is concave.

8. The device of any of the claims 1 to 7, wherein the substrate (30) further comprises porous silicon areas (46) arranged at the periphery of the substrate and extending from the first to the second surface.

9. The device of any of the claims 1 to 8, further comprising means capable of modifying the biasing of the transducers (32A, 32B) to adapt the resonance frequency of the transducers (34A, 34B) to the frequency of the acoustic wave.

Fig 1

Fig 2

Fig 3

Fig 4

Fig 5

Fig 6

32A    34A

38

30

40

32B    34B

44

**Fig 7**

32A    34A    42    44

38

30

40

46

32B    34B

46

**Fig 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2954014

- US 2013135970 A

**Littérature non-brevet citée dans la description**

- A flexible capacitive micromachined ultrasonic transducer (CMUT) array with increased effective capacitance from concave bottom electrodes for ultrasonic imaging applications. **CHING-HSIANG CHENG ; CHEN CHAO ; XIAOMEI SHI ; WALLACE LEUNG.** Ultrasonics Symposium (IUS). IEEE, 2009